Europäisches Patentamt

European Patent Office

Office européen des brevets

(19)

(11) Numéro de publication: **0 201 127**
**B1**

(12) **FASCICULE DE BREVET EUROPEEN**

(45) Date de publication du fascicule du brevet: 23.01.91

(51) Int. Cl.⁵: **H 01 L 31/105**

(21) Numéro de dépôt: 86200725.9

(22) Date de dépôt: 29.04.86

(54) **Photodiode PIN à faible courant de fuite.**

(30) Priorité: 03.05.85 FR 8506753

(43) Date de publication de la demande:
12.11.86 Bulletin 86/46

(45) Mention de la délivrance du brevet:
23.01.91 Bulletin 91/04

(84) Etats contractants désignés:
DE FR GB NL

(56) Documents cités:

EXTENDED ABSTRACTS OF THE 16th
INTERNATIONAL CONFERENCE ON SOLID
STATE DEVICES AND MATERIALS, 1984, papier
C-10-1, pages 579-582, Kobe, JP; KATSUYA
HASEGAWA et al.: "InGaAs PIN photodiode
with low-dark current"

ELECTRONICS LETTERS, vol. 20, no. 5, 1er mars
1984, pages 196-198, Londres, GB; K. LI et al.:
"InGaAs PIN photodiode fabricated on semi-
insulating InP substrate for monolithic
integration"

(73) Titulaire: **LABORATOIRES D'ELECTRONIQUE
PHILIPS**
**3, Avenue Descartes**
**F-94450 Limeil-Brévannes (FR)**
(84) FR

(73) Titulaire: **N.V. Philips' Gloeilampenfabrieken**
**Groenewoudseweg 1**
**NL-5621 BA Eindhoven (NL)**
(84) DE GB NL

(72) Inventeur: **Gentner, Jean-Louis**
**Société Civile S.P.I.D. 156 Boulevard Haussmann**
**F-75008 Paris (FR)**
Inventeur: **Patillon, Jean-Noel**
**Société Civile S.P.I.D. 156 Boulevard Haussmann**
**F-75008 Paris (FR)**
Inventeur: **Mallet-Mouko, Catherine**
**Société Civile S.P.I.D. 156 Boulevard Haussmann**
**F-75008 Paris (FR)**
Inventeur: **Martin, Gérard Marie**
**Société Civile S.P.I.D. 156 Boulevard Haussmann**
**F-75008 Paris (FR)**

(74) Mandataire: **Landousy, Christian et al**
**Société Civile S.P.I.D. 156, Boulevard
Haussmann**
**F-75008 Paris (FR)**

# EP 0 201 127 B1

(56) Documents cités:

SIEMENS FOSCH.- UND ENTWICKLUNGS-
BERICHTE, vol. 11, no. 4, 1982, pages 216-220,
Springer-Verlag, Würzburg, DE; R. TROMMER
et al.: "In0.53Ga0.47As/InP Pin and avalanche
photodiodes for the 1 mum to 1.6 mum
wavelength range"

IEEE ELECTRON DEVICE LETTERS, vol. EDL-2,
no. 9, septembre 1981, pages 217-219, IEEE,
New York, US; G.H. OLSEN: "Low-leakage,
high-efficiency, reliable VPE InGaAs 1.0-1.7
mum photodiodes"

JAPANESE JOURNAL OF APPLIED PHYSICS,
vol. 19, no. 3, 1980, pages 573-574; Y.
MATSUSHIMA et al.: "Dark-current of
In0.53Ga0.47-As/InP mesa-type avalanche
photodetector"

## Description

L'invention concerne une photodiode PIN à faible courant de fuite, constituée d'un substrat en phosphure d'indium (InP) dopé n$^+$ sur la première face duquel est réalisée une couche de phosphure d'indium (Inp) dopé n$^-$ surmontée d'une structure MESA formée à l'aide d'une couche d'arséniure de gallium et d'indium (InGaAs) dopée n$^-$, constituée en outre d'une couche de type p$^+$ réalisée en surface, sur les flancs et sur le pourtour de la structure MESA, et constituée enfin d'une part d'un contact métallique réalisé sur la seconde face du substrat et d'autre part d'un contact de type ohmique réalisé sur une partie de la couche de type p$^+$.

L'invention trouve son application dans la détection de rayonnement dans le domaine des longueurs d'onde situées entre 1µm et 1,7µm et en particulier aux longueurs d'onde 1,3µm et 1,55µm pour les applications aux télécommunications par exemple.

Une telle photodiode est connue de l'art antérieur par la publication de Katsuya Hasegawa et al dans "Extended Abstracts of the 16th International Conference on Solid State Devices and Materials, Kobe, 1984, pp. 579-582, C-10-1" intitulée "InGaAs PIN Photodiode with Low-Dark Current".

Ce document décrit une photodiode PIN constituée d'un substrat en phosphure d'indium (InP) dopé n$^+$ sur la première face duquel est réalisée par épitaxie en phase liquide une couche de phosphure d'indium (InP) dopée n$^-$ dont la concentration en porteurs est de l'ordre de $5.10^{15}$ cm$^{-3}$. Une couche d'arséniure de gallium et d'indium dopée n$^-$, dont la concentration en porteurs est également de l'ordre de $5.10^{15}$ cm$^{-3}$, est déposée par la même méthode d'épitaxie en phase liquide sur la couche de phosphure d'indium (Inp) n$^-$ et gravée de manière à constituer une structure MESA. Une couche de type p$^+$ est ensuite formée par diffusion d'ions Zn non seulement en surface de la structure MESA mais encore sur les flancs et sur tout le pourtour La profondeur de diffusion est de 0,5µm en surface de la structure MESA dans la couche d'InP. Un contact ohmique de forme annulaire est alors réalisé à l'aide d'un alliage Ti/Au en surface de la structure MESA, et un contact métallique Au/Sn/Au est formé sur la surface du substrat opposée à la structure MESA. Enfin une couche de passivation de nitrure de silicium Si$_3$N$_4$, servant également de revêtement antiréfléchissant est déposée au centre du contact ohmique annulaire en surface de la structure MESA et sur les flancs et le pourtour de cette dernière.

Ces photodiodes présentent trois avantages sur les dispositifs qui leurs étaient antérieurs. Premièrement comme le bord extérieur de la région p$^+$ est situé en surface de la couche d'InP, le courant de fuite est diminué. Deuxièmement, la passivation par une couche de nitrure de silicium étendue jusqu'au pourtour de la diode permet d'obtenir une meilleure efficacité quantique et une bonne durée de vie de la diode. Troisièmement, la formation d'une couche relativement épaisse de type p$^+$ autour de la structure MESA constitue un anneau de garde de réalisation simplifiée et diminue l'effet tunnel.

Or les photodiodes réalisées à l'aide de semiconducteurs du groupe III-V sont actuellement d'une grande importance industrielle dans les dispositifs optiques ou électrooptique fonctionnant dans le domaine des longueurs d'onde comprises entre 1µm et 1,7µm. Pour les applications aux télécommunications qui utilisent les longueurs d'onde 1,3µm et 1,55µm, les normes imposées, qui sont assez sévères, poussent à améliorer encore les résultats obtenus avec les diodes décrites dans le document cité.

En effet, ces diodes connues présentent, en dehors des qualités énumérées plus haut, un certain nombre d'inconvénients. En particulier, il est nécessaire d'avoir une épaisseur d'au moins 0,5µm entre la surface sur laquelle on prend le contact ohmique -en l'occurence la surface de la couche d'InGaAs du MESA- et la jonction de manière à éviter la dégradation de la jonction. Mais, comme cette distance est grande, l'absorption due au matériau InGaAs type p$^+$ est également grande et par conséquent le rendement faible. De plus la capacité intrinsèque de la diode est élevée. Enfin dans les couches réalisées par épitaxie en phase liquide, le dopage n$^-$ est difficile à contrôler et on obtient le plus souvent un dopage n$^-$ dans la couche d'InP qui se révèle être supérieur au dopage n$^-$ obtenu dans la couche d'InGaAs.

C'est pourquoi, la présente invention propose une solution à ces problèmes au moyen d'une diode telle que définie dans le préambule, caractérisée en ce que le dopage n$^-$ de la couche de phosphure d'indium (InP) est réalisé plus faible que le dopage n$^-$ de la couche d'arséniure de gallium et d'indium (InGaAs), et en ce que le contact ohmique est pris sur une partie de la zone p$^+$ localisée dans la couche de phosphure d'indium (InP) sur le pourtour de la structure MESA.

Selon l'invention, la capacité intrinsèque de la diode est diminuée par rapport à l'art antérieur cité, du fait que le dopage n$^-$ de la couche d'Inp sur laquelle est pris le contact ohmique est inférieur au dopage n$^-$ de la couche d'InGaAs formant la structure MESA.

Selon une réalisation préférentielle de l'invention, cette photodiode est en outre caractérisée en ce que l'épaisseur de la couche p$^+$ formée en surface de la couche d'arséniure de gallium et d'indium (InGaAs) est inférieure à l'épaisseur de la zone p$^+$ formée sous le contact ohmique dans la couche de phosphure d'indium (InP).

Du fait que le contact ohmique n'est plus placé au sommet du MESA comme selon l'art antérieur, l'épaisseur de la couche p$^+$ sous le contact ohmique peut être différente de celle de la couche p$^+$ sur le MESA et chacune de ces épaisseurs peut être optimisée.

Selon cette réalisation, l'épaisseur de la couche p$^+$ en surface de la couche d'arséniure de gallium et d'indium peut être réduite, ce qui procure l'avantage d'augmenter le rendement de la diode, car le matériau d'arséniure de gallium et d'indium de type p$^+$ est fortement absorbant dans les longueurs d'onde envisagées. Au contraire l'épaisseur de la couche p$^+$ dans le phosphure d'indium sous le contact ohmique peut être prévue de grandeur suffisante à rendre le contact plus facile à réaliser et plus stable dans le temps.

Selon une variante de cette réalisation préférentielle, cette photodiode est caractérisée de plus en ce que la structure MESA ainsi constituée est surmontée d'une couche de phosphure d'indium (Inp) de type p$^+$.

Une photodiode conforme à ces réalisation préférentielles peut être caractérisée en ce que l'épaisseur de la couche de phosphure d'indium (InP) type n$^-$ et d'arséniure de gallium et d'indium (InGaAs) est de l'ordre de 3μm, en ce que le dopage n$^-$ de la couche de phosphure d'indium (Inp) est environ 2.10$^{14}$ cm$^{-3}$, le dopage n$^-$ de la couche d'arséniure de gallium et d'indium (InGaAs) est de l'ordre de 1 à 2.10$^{15}$ cm$^{-3}$, en ce que l'épaisseur de la zone p$^+$ réalisée dans la couche de phosphure d'indium (InP) sur le pourtour de la structure MESA est supérieure à 0,5μm, alors que l'épaisseur de la couche d'arséniure de gallium et d'indium type p$^+$ réalisée en surface de la couche d'arséniure de gallium et d'indium type n$^-$ est de l'ordre de 0,1 à 0,2μm.

Dans cette forme de réalisation de la photodiode, toutes les valeurs des dopages et des épaisseurs de couches sont optimales et permettent d'obtenir la capacité la plus faible, le rendement le meilleur et l'efficacité quantique la plus élevée possible.

L'invention concerne aussi un procédé de réalisation d'une telle photodiode. Les photodiodes réalisées au moyen de ce procédé présentent à la fois un faible courant d'obscurité, une faible capacité de jonction, une bonne efficacité quantique et une grande durée de vie.

Un second procédé de réalisation, permettant d'obtenir une photodiode conforme à ladite variante de l'invention est également proposé. Les photodiodes obtenues selon ce procédé sont d'une réalisation particulièrement aisée. L'existence de la couche de phosphure d'indium type p$^+$ au sommet du MESA, couche qui est parfaitement transparente au rayonnement de longueur d'onde 1 à 1,7μm envisagé, permet de contrôler facilement et donc de mieux limiter l'épaisseur de la couche p$^+$ en surface de la couche d'arséniure de gallium et d'indium qui est, quant à elle, fortement absorbante à ces longueurs d'onde. D'autre part, la localisation de la jonction p-n sous le contact ohmique en pourtour du MESA, est selon ce procédé également particulièrement aisée à contrôler.

L'invention sera mieux comprise à l'aide de la description suivante illustrée par les figures annexées dont:

la figure 1a qui représente en coupe la photodiode selon l'invention,

la figure 1b qui représente en coupe la photodiode selon la variante de l'invention,

la figure 2 qui représente l'une ou l'autre photodiode vue du dessus,

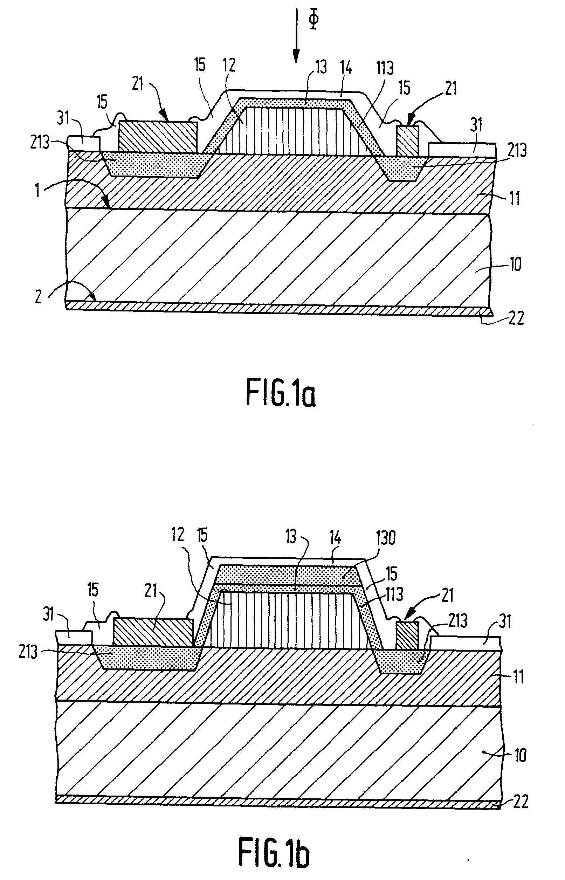

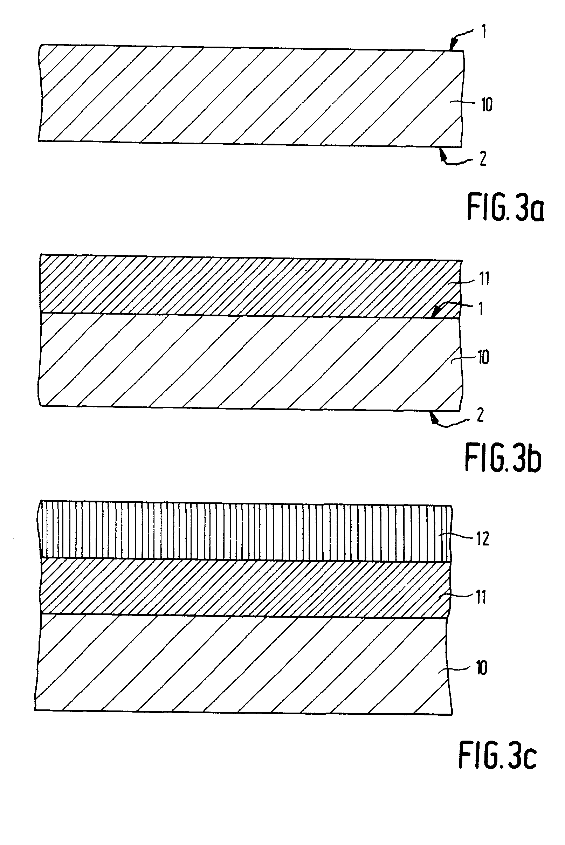

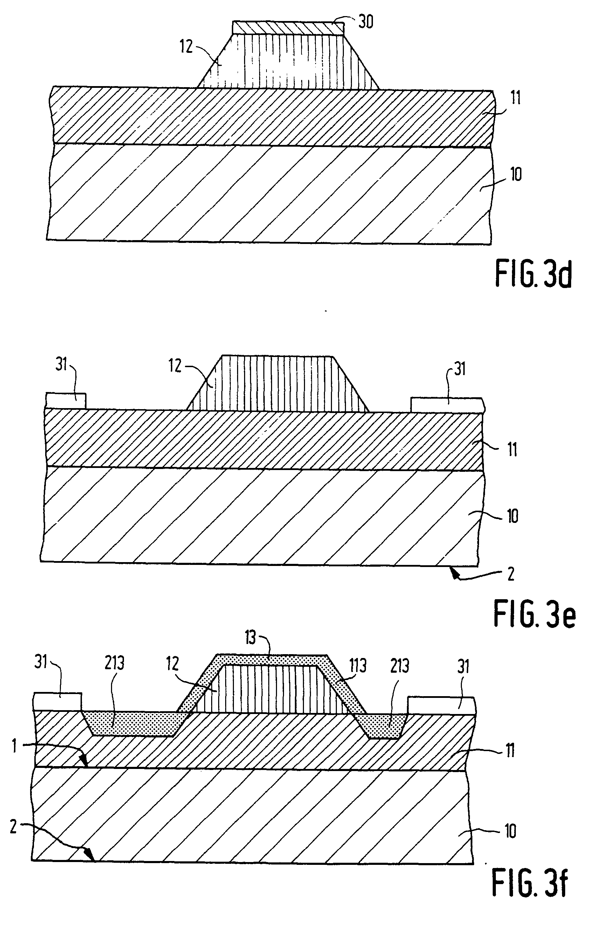

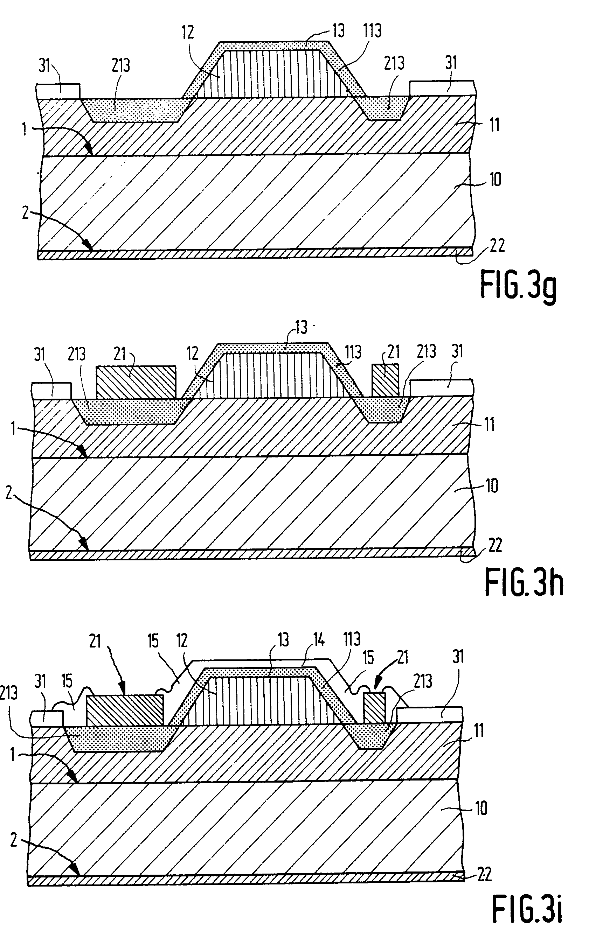

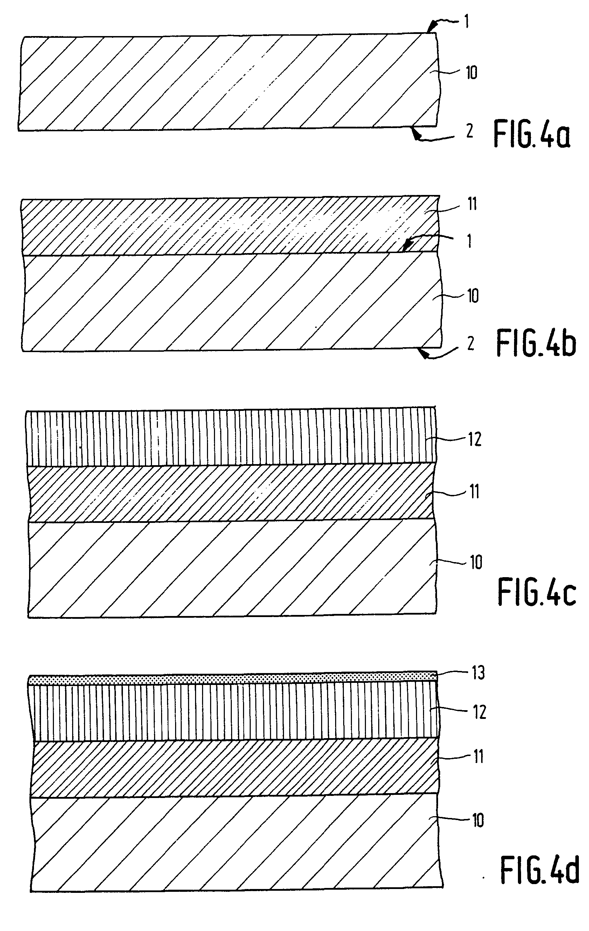

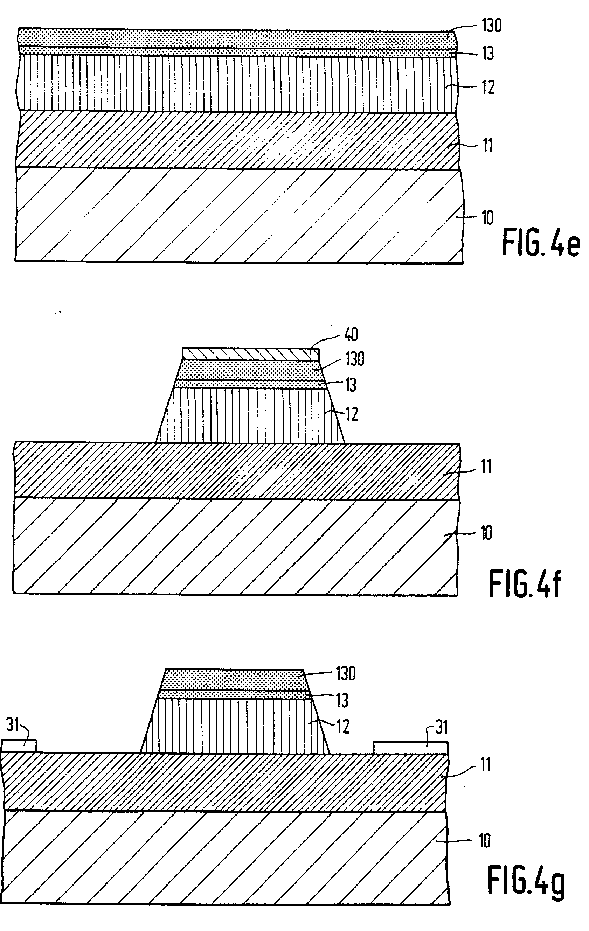

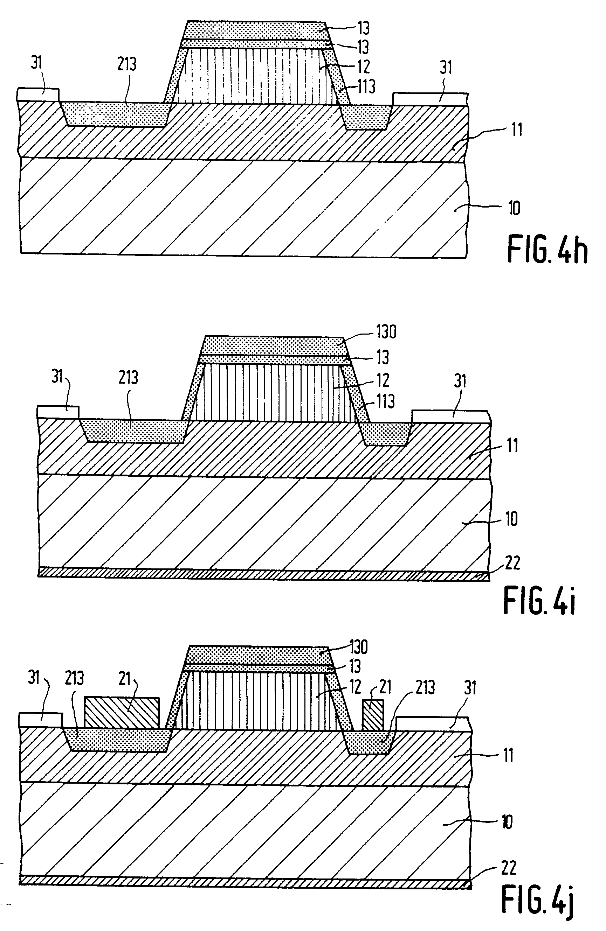

l'ensemble des figures 3 qui illustre les différentes étapes du procédé de réalisation permettant d'obtenir une diode conforme à la diode représentée figure 1a,

l'ensemble des figures 4 qui illustre les différentes étapes du procédé de réalisation permettant d'obtenir une diode conforme à la diode représentée figure 1b.

Telle que représentée en coupe sur la figure 1a, la photodiode PIN selon l'invention comprend un substrat 10 de phosphure d'indium (InP) de type n$^+$, une couche 11 de phosphure d'indium (Inp) de type n$^-$ réalisée sur une première face 1 du substrat, une structure MESA 12 formée d'une couche d'arséniure de gallium et d'indium (InGaAs) de type n$^-$, une couche 13, 113 et 213, de type p$^+$ réalisée dans les zones de type n$^-$ de manière à constituer une jonction p-n, et deux contacts, l'un 21 pris sur la zone 213 de type p$^+$ et l'autre 22 pris sur la seconde face 2 du substrat 10.

Cette photodiode PIN reçoit le rayonnement φ sur la face supérieure de la structure MESA. Les matériaux utilisés d'InP/InGaAs permettent l'utilisation de la diode dans le domaine des longueurs d'onde compris entre 1μm et 1,7μm, et plus particulièrement aux longueurs d'onde utilisées en télécommunications telles que 1,3μm et 1,55μm.

La couche 13, 113, 213 de type p$^+$ est réalisée de telle sorte qu'elle couvre la surface (pour la partie 13), les flancs (pour la partie 113) et le pourtour (pour la partie 213) du MESA. Dans ces conditions, le bord de la jonction p-n apparaît dans la couche de phosphure d'indium (InP) 11, et non pas dans la couche 12 d'arséniure de gallium et d'indium (InGaAs), comme il est courant de le rencontrer dans de nombreux dispositifs connus de l'homme de l'art, et la configuration de la diode selon l'invention entraîne que le courant de fuite est particulièrement faible. Cet avantage était déjà connu de la publication citée comme art antérieur.

Mais, selon l'invention le dopage de la couche 11 de phosphure d'indium (InP) est réalisé de manière à être inférieur au dopage de la couche 12 d'arséniure de gallium et d'indium (InGaAs), et d'autre part le contact 21 de type ohmique est réalisée en surface de la zone 213 p$^+$ située sur le pourtour du MESA. le dopage de la couche 11 d'InP pourra être de l'ordre de 2.10$^{14}$ porteurs par cm$^3$ alors que le dopage de la couche 12 d'InGaAs sera de préférence de l'ordre de 1 à 2.10$^{15}$ porteurs par cm$^3$. Ce taux de dopage est très différent du taux de dopage des couches de la photodiode décrite dans le document cité comme art antérieur, où les taux étaient à peu près équivalents pour les deux couches et de l'ordre de 5.10$^{15}$ cm$^{-3}$. Pour obtenir le taux de dopage désiré à la mise en oeuvre de la présente invention, on choisira de préférence, au lieu de la croissance épitaxiale en phase liquide préconisée par l'art antérieur, une méthode de croissance en phase vapeur aux organo-métalliques. Selon cette méthode, en effet, les taux de dopage résiduel de chacune des couches, d'InP et de InGaAs respectivement, sont précisément de l'ordre de grandeur des taux désirés, ce qui constitue une mise en oeuvre particulièrement aisée de l'invention. Au contraire, la méthode de croissance en phase liquide selon l'art antérieur, fournit des couches dont les taux de dopage sont le plus souvent inversés par rapport aux taux voulus pour les couches constituant la photodiode selon l'invention.

Du fait que le contact ohmique 21 est pris audessus de la couche d'InP dont le dopage est inférieur à celui de la couche d'InGaAs, alors la capacité de jonction de la photodiode ainsi formée est considérablement réduite par rapport à la capacité de la photodiode selon l'art antérieur.

D'autre part, en plaçant le contact ohmique 21 sur le pourtour du MESA, on obtient encore deux avantages supplémentaires.

En premier lieu, il est aisé d'obtenir une bonne efficacité quantique. Cette dernière est liée à l'épaisseur de la couche 13 de type $p^+$ en surface du MESA. Une très bonneefficacité quantique est obtenue pour une épaisseur de cette couche de l'ordre de 1 à 2µm.

Selon l'art antérieur, la couche $p^+$ devait présenter en surface du MESA une épaisseur d'au moins 0,5µm puisque le contact y était localisé. Cette disposition procurait un inconvénient du fait que le matériau InGaAs $p^+$ est justement très absorbant aux longueurs d'onde de fonctionnement de la diode (1 à 1,7µm). Il est donc tout à fait désavantageux d'être obligé d'avoir une couche d'InGaAs $p^+$ aussi épaisse que 0,5µm en surface du MESA.

C'est pourquoi selon la présente invention on obtient la structure désirée, en réalisant par exemple une diffusion $p^+$ telle qu'elle progresse moins vite dans le matériau InGaAs que dans le matériau InP. En sorte que, lorsque cette diffusion $p^+$ atteint l'épaisseur supérieure à 0,5µm, nécessaire à la réalisation d'un contact ohmique fiable, dans InP, l'épaisseur de la diffusion $p^+$ dans InGaAs en surface du MESA n'est encore qu'environ 0,1 à 0,2µm, ce qui diminue l'absorption et améliore le rendement.

Dans un exemple de réalisation de l'invention, les concentrations des composants du matériau InGaAs formant le MESA sont tels que celui-ci présente la formule $In_{0.3}Ga_{0.47}As$. L'épaisseur de chacune des couches d'InP et de InGaAs est de l'ordre de 3µm. Le contact ohmique 21 est formé par la superposition de couches de chrome-platineor, ou bien encore de platine-titane-or. Le contact 22 réalisé sur la face 2 arrière du substrat est formé par la superposition de couches d'or-germanium-nickel.

Il peut être réalisé, en outre, en surface de la structure MESA une couche de diélectrique d'épaisseur appropriée à former une couche antireflet 14 pour le domaine des longueurs d'onde de fonctionnement de la photodiode. Ce diélectrique peut être la silice ($SiO_2$) ou le nitrure de silicium ($Si_3N_4$) par exemple. Et il peut être enfin réalisé, sur les flancs de la structure MESA une couche de diélectrique 15 destinée à constituer une couche de passivation pour le dispositif. Ce diélectrique peut être la silice ($SiO_2$), le nitrure de silicium ($Si_3N_4$) ou encore le polyimide par exemple.

Dans ces conditions la photodiode selon l'invention présente non seulement les avantages connus de l'art antérieur cité, c'est-à-dire un très faible courant de fuite, une bonne durée de vie, un faible effet tunnel mais encore les avantages supplémentaires dus à la structure caractéristique de l'invention, c'est-à-dire une capacité de jonction plus faible, une meilleure efficacité quantique et un meilleur rendement aux longueurs d'onde utilisées.

A titre d'exemple, un procédé de réalisation de la photodiode correspondant à cette figure 1a est alors proposé. Ce procédé illustré par les différentes figures 3 comprend les étapes successives de:

a) formation d'un substrat 10 en phosphure d'indium (InP) dopé $n^+$ par des atomes de soufre $S^+$ par exemple (figure 3a). Ce matériau peut être obtenu par croissance Czochralski par exemple;

b) dépôt sur la première face 1 de ce substrat d'une couche 11 de phosphure d'indium (InP) de type $n^-$, d'épaisseur environ 3µm. Le niveau de dopage préférentiel est de l'ordre de $2.10^{14}$ porteurs par $cm^3$ et peut être obtenu comme dopage résiduel lorsque la couche d'InP est élaborée par une méthode de croissance épitaxiale en phase vapeur aux organo-métalliques (figure 3b);

c) dépôt sur la couche 11 d'InP, d'une couche 12 d'arséniure de gallium et d'indium ($In_{0.53}Ga_{0.47}As$ par exemple) dont le paramètre de maille est adapté au paramètre de maille de la couche précédente, de type $n^-$, d'épaisseur environ 3µm. Le niveau de dopage préférentiel est de l'ordre de 1 à $2.10^{15}$ et peut être constitué par le dopage résiduel obtenu lorsque la couche de InGaAs est élaborée par une méthode de croissance épitaxiale en phase vapeur aux organométalliques. En tous les cas, le niveau de dopage de la couche d'Inp doit être réalisé inférieur au niveau de dopage de la couche de InGaAs pour obtenir la diminution de la capacité de jonction du dispositif final (figure 3c);

d) protection par exemple par un masque 30 de la surface destinée à constituer le MESA, et gravure sélective de la couche d'arséniure de gallium et d'indium (InGaAs) en dehors de la zone protégée, de manière à faire apparaître la couche 11 d'InP autour du MESA, lequel est constitué de la partie protégée de la couche 12 d'InGaAs (figure 3d), puis élimination du masque 30. La gravure sélective du matériau InGaAs peut être faite chimiquement par une solution d'acide sulfurique puis rinçage à l'eau;

e) dépôt sur la couche 11 de phosphure d'indium (InP) d'une couche diélectrique 31 définissant une ouverture de diamètre supérieur au diamètre du MESA, autour du MESA. Cette ouverture est destinée à délimiter la diffusion de la région $p^+$. Le diélectrique peut être la silice ($SiO_2$)

ou le nitrure de silicium ($Si_3N_4$), ces composés étant cités à titre d'exemple non limitatif (figure 3e);

f) diffusion, dans l'ouverture de la couche diélectrique 31, d'atomes tels que Zn par exemple, pour former la couche de type $p^+$, cette couche étant notée 13 en surface du MESA, 113 sur les flancs et 213 sur le pourtour du MESA, par une méthode d'ampoule scellée, de manière à ce que la profondeur de diffusion dans la couche de InGaAs en surface du MESA soit inférieure à la profondeur de diffusion dans la couche d'InP sur le pourtour du MESA. De manière préférentielle, la profondeur de diffusion dans la couche d'InP sur le pourtour du MESA atteindra au moins $0,5\mu m$ alors que la profondeur de diffusion dans la couche de InGaAs en surface du MESA sera de l'ordre de 0,1 à $0,2\mu m$ (figure 3f);

g) réalisation d'un contact métallique 22 sur la face arrière 2 du substrat 10, par exemple par évaporations successives d'or, de germanium et de nickel pour former une superposition de couches (figure 3g);

h) réalisation sur la partie 213 de la zone $p^+$ située dans la couche d'InP sur le pourtour du MESA, d'un contact de type ohmique 21. Ce contact peut être réalisé par évaporation successive de chrome, de platine et d'or ou encore de platine, de titane et d'or pour former des couches superposées (figure 3h);

i) réalisation à l'aide d'un diélectrique tel que par exemple la silice ($SiO_2$), le nitrure de silicium ($Si_3N_4$) d'une couche antireflet 14 en surface du MESA, l'épaisseur de cette couche étant telle qu'elle présente un maximum de transmission dans le domaine des longueurs d'onde de fonctionnement de la photodiode (figure 3i);

j) réalisation sur les flancs du MESA d'une couche diélectrique 15 destinée à constituer une couche de passivation pour la photodiode. Cette couche peut être du même matériau que ou compatible avec la couche antireflet (figure 3i). Ce peut donc être par exemple la silice, le nitrure de silicium ou le polyimide.

Ce procédé de réalisation est donné tout à fait à titre d'exemple, car il est bien évident que les couches 13, 113, 213 d'arséniure de gallium et d'indium de type $p^+$ peuvent être réalisées encore par l'association d'une croissance épitaxiale pour une partie (couche 13) et d'une diffusion pour une autre partie (couches 113 et 213).

Dans le but de réaliser une photodiode pour laquelle la localisation de la jonction p-n est plus facile à contrôler, une variante de la diode selon l'invention est proposée. Cette variante est représentée sur la figure 1b. Selon cette variante, la couche 13 d'arséniure de gallium et d'indium, de type $p^+$, est surmontée sur la surface plane du MESA, d'une couche de phosphure d'indium (InP) 130, de type $p^+$. Dans le domaine des longueurs d'onde où la photodiode est utilisée, c'est-à-dire 1 à $1,7\mu m$, le matériau InP type $p^+$ est parfaitement transparent au rayonnement, alors que, comme il a été dit précédemment le matériau InGaAs type $p^+$ est fortement absorbant. C'est pourquoi il est extrêmement important de diminuer autant que faire se peut, et en tous cas de bien contrôler, l'épaisseur de la couche 13 d'InGaAs type $p^+$. L'existence de la couche 130 d'InP de type $p^+$ permet de diminuer au maximum l'épaisseur de la couche d'InGaAs de type $p^+$. Cette variante représentée sur la figure 1b offre l'avantage de pouvoir être réalisée à l'aide d'un procédé selon lequel la localisation de la jonction p-n est facilement contrôlable. Ce procédé de réalisation est proposé à titre d'exemple ciaprès. Il comprend tout d'abord des étapes, notées a', b' et c' tout à fait identiques aux étapes a,b,c du procédé précédemment décrit. Ces étapes a',b',c' sont illustrées respectivement par les figures 4a, 4b, 4c, la couche 11 constituant dans ce procédé une première couche de phosphure d'indium (InP). Ces opérations sont suivies des étapes ultérieures de:

d') dépôt d'une couche d'arséniure de gallium et d'indium (InGaAs) 13 de type $p^+$, d'épaisseur environ 0,1 à $0,2\mu m$, sur la couche d'arséniure de gallium et d'indium 12 (InGaAs) de type $n^-$ précédente, par exemple par croissance épitaxiale en phase vapeur, le dopant étant par exemple le zinc (figure 4d);

e') dépôt d'une seconde couche de phosphure d'indium 130 (InP), de type $p^+$, d'épaisseur environ $1\mu m$, par exemple par épitaxie en phase vapeur, le dopant étant par exemple le zinc (figure 4e);

f') protection de la surface destinée à constituer le MESA par exemple par un masque 40, gravure sélective de la seconde couche de phosphure d'indium 130 (InP) et des couches 12 et 13 d'arséniure de gallium et d'indium (InGaAs), par exemple par voie chimique (figure 4f);

g') dépôt sur la première couche 11 de phosphure d'indium, d'une couche diélectrique 31, telle que par exemple de la silice ($SiO_2$) ou du nitrure de silicium ($Si_3N_4$), définissant une ouverture de diamètre supérieur à celui du MESA, autour du MESA (figure 4g);

h') diffusion d'atomes, comme par exemple Zn, dans une ampoule scellée dans la première couche de phosphure d'indium 11 (InP) autour du MESA sur une profondeur d'au moins $0,5\mu m$, sur les flancs du MESA et en surface du MESA, cette opération constituant une couche de type $p^+$ notée 113 sur les flancs, et 213 sur le pourtour du MESA, dans l'ouverture de la couche diélectrique 31 précédemment réalisée (figure 4h);

i') réalisation d'une métallisation 22 sur la face arrière du substrat, par exemple à l'aide d'une superposition de couches or-germanium-nickel (Au-Ge-Ni) (figure 4i);

j') réalisation sur la zone 213 $p^+$ formée dans la première couche de phosphure d'indium (Inp) 11 sur le pourtour du MESA, d'un contact de type ohmique 21, par exemple à l'aide d'une superposition de couches de chromeplatine-or, ou de platine-titane-or (figure 4j);

k') réalisation, à l'aide d-un diélectrique tel que par exemple la silice ($SiO_2$), ou le nitrure ($Si_3N_4$)

d'une couche antireflet 14 à la surface du MESA, couche centrée sur la longueur d'onde d'utilisation de la photodiode;

l') réalisation sur les flancs du MESA d'une couche de passivation 15 à l'aide d'un diélectrique analogue à et compatible avec le diélectrique constituant la couche antireflet (figure 1b). Ce diélectrique peut donc être la silice ($SiO_2$), le nitrure de silicium ($Si_3N_4$) ou encore le polyimide.

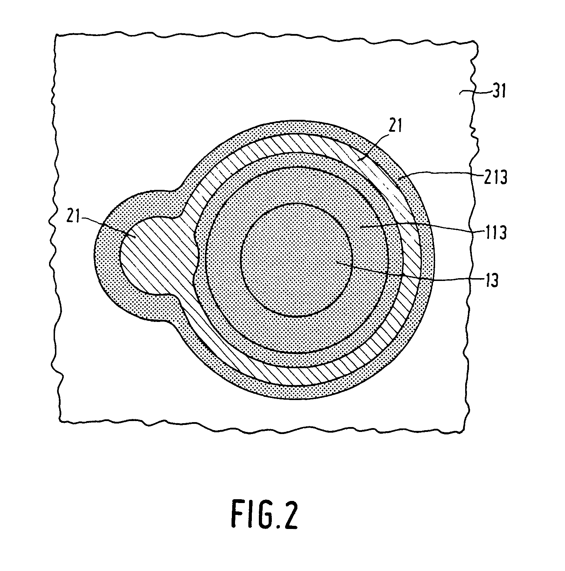

La figure 2 montre vue du dessus l'une ou l'autres des diodes représentées respectivement en coupe figure 1a et figure 1b. On notera que le contact 21 présente une forme annulaire préférable pour améliorer le contact sur Inp qui est connu comme présentant des difficultés.

La structure MESA 14 est circulaire et de diamètre environ 100µm. le contact ohmique 21 est circulaire et d'un diamètre d'environ 60µm, il est décentré par rapport au MESA pour être pris sur la couche d'InP. La zone 213 de type $p^+$ située sous le contact 21 et sur le pourtour du MESA forme donc un anneau de garde.

Les procédés de réalisation cités à titre d'exemple mettent en oeuvre, entre autres, des procédés de masquages et de dépôts qui ne sont pas décrits ici, comme ne faisant pas à proprement parler partie de l'invention, et étant supposés facilement accessibles à, ou connus de, l'homme de l'art.

Il est évident que les matériaux et les procédés de réalisation cités à titre d'exemple pour réaliser la photodiode selon l'invention ne sont pas limitatifs et que des matériaux équivalents et des procédés de réalisation similaires peuvent être envisagés pour réaliser cette photodiode sans pour autant sortir du cadre de la présente invention tel que défini par les revendications ci-après annexées.

**Revendications**

1. Photodiode PIN à faible courant de fuite, constituée d'un substrat en phosphure d'indium (InP) de type $n^+$ sur la première face duquel est réalisée une couche de phosphure d'indium (InP) de type $n^-$ surmontée d'une structure MESA formée à l'aide d'une couche d'arséniure de gallium et d'indium (InGaAs) de type $n^-$, constituée en outre d'une couche de type $p^+$ réalisée en surface, sur les flancs et sur le pourtour de la structure MESA, et constituée enfin d'une part d'un contact métallique réalisé sur la seconde face du substrat opposée à la première et d'autre part d'un contact de type ohmique réalisé sur une partie de la couche de type $p^+$, caractérisé en ce que la concentration de dopage $n^-$ de la couche de phosphure d'indium (InP) est plus faible que la concentration de dopage $n^-$ de la couche d'arséniure de gallium et d'indium (InGaAs), et en ce que le contact ohmique est pris sur une partie de la zone $p^+$ localisée dans la couche de phosphure d'indium (Inp) de type $n^-$ sur le pourtour de la structure MESA.

2. Photodiode selon la revendication 1, caractérisée en ce que l'épaisseur de la couche $p^+$ formée en surface de la couche d'arséniure de gallium et d'indium (InGaAs) de type $n^-$ est inférieure à l'épaisseur de la zone $p^+$ formée sous le contact ohmique dans la couche de phosphure d'indium (InP) de type $n^-$ sur le pourtour du MESA.

3. Photodiode selon la revendication 2, caractérisé en ce que la structure MESA ainsi constituée est surmontée d'une seconde couche de phosphure d'indium (InP) de type $p^+$.

4. Photodiode selon la revendication 3, caractérisée en ce que la seconde couche de phosphure d'indium de type $p^+$ réalisée en surface de la couche d'arséniure de gallium et d'indium de type $p^+$ a une épaisseur de l'ordre de 1µm.

5. Photodiode selon l'une des revendications 2, 3 ou 4, caractérisée en ce que l'épaisseur de la couche de phosphure d'indium (InP) de type $n^-$ et de la couche d'arséniure de gallium et d'indium (InGaAs) de type $n^-$ est de l'ordre de 3µm, le dopage $n^-$ de la couche de phosphure d'indium (InP) est de l'ordre de $2.10^{14}$ porteurs par $cm^3$, le dopage $n^-$ de la couche d'arséniure de gallium et d'indium (InGaAs) est de l'ordre de 1 à $2.10^{15}$ porteurs par $cm^3$, l'épaisseur de la zone $p^+$ réalisée dans la couche de phosphure d'indium (Inp) de type $n^-$ sur le pourtour de la structure MESA est supérieure à 0,5µm, alors que l'épaisseur de la couche de type $p^+$, réalisée en surface de la couche d'arséniure de gallium et d'indium de type $n^-$, est de l'ordre de 0,1 à 0,2µm.

6. Procédé de réaliation d'une diode selon l'une des revendications 1 à 5, caractérisé en ce qu'il comprend les étapes de:

a) formation d'un substrat de phosphure d'indium (Inp) de type $n^+$;

b) dépôt d'une couche de phosphure d'indium, de type $n^-$ d'épaisseur environ 3µm;

c) dépôt d'une couche d'arséniure de gallium et d'indium, de type $n^-$, de niveau de dopage supérieur à celui de la couche précédente en InP, d'épaisseur environ 3µm;

d) protection de la surface destinée à constituer le MESA, gravure sélective de la couche d'arséniure de gallium et d'indium (InGaAs) puis élimination de la protection de la surface du MESA.

e) dépôt sur la couche de phosphure d'indium de type $n^-$ d'une couche diélectrique, définissant une ouverture de diamètre supérieur à celui du MESA, autour du MESA;

f) diffusion d'atomes accepteurs de manière telle que la profondeur de diffusion dans la couche de phosphure d'indium (InP) de type $n^-$ soit plus grande que la profondeur de diffusion dans la couche d'arséniure de gallium et d'indium, en sorte que la profondeur de diffusion dans le phosphure d'indium (InP) est au moins égale à 0,5µm et que la profondeur de diffusion dans l'arséniure de gallium et d'indium (InGaAs) est de l'ordre de 0,1 à 0,2µm, cette opération constituant une couche de type $p^+$ à la surface, sur les flancs et sur le pourtour du MESA, dans l'ouverture de la couche diélectrique précédemment réalisée,

g) réalisation d'une métallisation sur la face arrière du substrat,

h) réalisation sur la zone p$^+$ formée dans la couche de phosphure d'indium (Inp) de type n$^-$ sur le pourtour du MESA d'un contact de type ohmique,

i) réalisation d'une couche diélectrique antireflet à la surface du MESA, couche dont la transparence est centrée sur la longueur d'onde d'utilisation de la photodiode,

j) réalisation les flancs du MESA d'une couche diélectrique de passivation analogue à et compatible avec le diélectrique constituant la couche antireflet.

7. procédé selon la revendication 6, caractérisé en ce qu'entre les étapes c et d il comprend les étapes:

k) dépôt d'une couche d'arséniure de gallium et d'indium (InGaAs) de type p$^+$, d'épaisseur environ 0,1 à 0,2μm, sur la couche d'arséniure de gallium et d'indium (InGaAs) de type n$^-$ précédente,

l) dépôt d'une seconde couche de phosphure d'indium (InP), de type p$^+$, d'épaisseur environ 1μm, par épitaxie.

**Patentansprüche**

1. PIN-Photodiode mit niedrigem Leckstrommit einem Träger aus n$^+$-leitendem Indiumphosphid (InP), auf dessen erster Oberfläche eine n$^-$-leitende Indiumphosphidschicht (InP) gebildet wird, auf der eine durch eine n$^-$-leitende Gallium-Indium-Arsenidschicht (InGaAs) gebildete MESA-Struktur vorgesehen wird, weiterhin mit einer auf der Oberfläche, an den Rändern und am Umfang der MESA-Struktur gebildeten p$^+$-leitende Schicht, und zum Schluss einerseits mit einem metallischen Kontakt auf der, der ersten Oberfläche gegenüberliegenden Oberfläche des Trägers, und andererseits mit einem Ohmschen Kontakt auf einem Teil der p$^+$-leitenden Schicht, dadurch gekennzeichnet daß die Konzentration der n$^-$-Dotierung der Indium-Phosphide-Schicht (InP) niedriger ist als die Konzentration der n$^-$-Dotierung der Gallium-Indium-Arsenid-Schicht (InGaAs), und daß der ohmsche Kontakt auf einem Teil der p$^+$-Zone in der n$^-$-leitenden Indiumphosphidschicht (InP) am Umfang der MESA-Struktur gebildet ist.

2. Photodiode nach Anspruch 1, dadurch gekennzeicbnet daß die Dicke der auf der Oberfläche der n$^-$-leitenden Gallium-Indium-Arsenidschicht (InGaAs) gebildeten p$^+$-Schicht geringer ist als die Dicke der unter dem ohmschen Kontakt in der n$^-$-leitenden Indiumphosphidschicht (InP) am Umfang der MESA-Struktur gebildeten p$^+$-Zone.

3. Photodiode nach Anspruch 2, dadurch gekennzeichnet, daß die auf diese Weise gebildete MESA-Struktur mit einer zweiten p$^+$-leitenden Indiumphosphidschicht (InP) versehen ist.

4. Photodiode nach Anspruch 3, dadurch gekennzeichnet, daß die zweite p$^+$-leitende Indiumphosphidschicht auf der Oberfläche der p$^+$-leitenden Gallium-Indium-Arsenidschicht eine Dicke hat in der Größenordnung von 1 μm.

5. Photodiode nach einem der Ansprüche 2, 3 oder 4, dadurch gekennzeichnet, daß die Dicke der n$^-$-leitenden Indiumphosphidschicht (InP) und der n$^-$-leitenden Gallium-Indium-Arsenidschicht (InGaAs) in der Größenordnung von 3 μm liegt, wobei die n$^-$-Dotierung der Indiumphosphidschicht (Inp) in der Größenordnung von $2.10^{14}$ Ladungsträgern / cm$^3$ liegt, während die n$^-$-Dotierung der Gallium-Indium-Arsenidschicht (InGaAs) in der Größenordnung von 1 bis $2.10^{15}$ Ladungsträgern / cm$^3$ liegt, wobei die Dicke der in der n$^-$-leitenden Indiumphosphidschicht (InP) gebildeten p$^+$-Zone am Umfang der MESA-Struktur größer ist als 0,5 μm, während die Dicke der auf der Oberfläche der n$^-$-leitenden Gallium-Indium-Arsenidschicht gebildeten p$^+$-leitenden Schicht in der Größenordnung von 0,1 bis 0,2 μm liegt.

6. Verfahren zum Herstellen einer Diode nach einem der Ansprüche 1 bis 5, dadurch gekennzeichnet, daß das Verfahren die nachfolgenden Verfahrensschritte aufweist:

a) die Bildung eines n$^+$-leitenden Indiumphosphidträgers (InP);

b) das Niederschlagen einer n$^-$-leitenden Indiumphosphidschicht mit einer Dicke von etwa 3 μm;

c) das Niederschlagen einer n$^-$-leitenden Gallium-Indium-Arsenidschicht, wobei der Dotierungspegel höher ist als der der vorhergehenden InP-Schicht mit einer Dicke von etwa 3 μm;

d) das Maskieren der Oberfläche zum Anbringen der MESA, das selektive Atzen der Gallium-Indium-Arsenidschicht (InGaAs) mit nachfolgender Entfernung der Maskierung von der Oberfläche der MESA;

e) das Niederschlagen einer dielektrischen Schicht auf der n$^-$-leitenden Indiumphosphidschicht, wobei diese dielektrische Schicht eine Öffnung um die MESA definiert, deren Durchmesser größer ist als der der MESA;

f) das Diffundieren von Akzeptoratomen, und zwar derart, daß die Difussionstiefe in der n$^-$-leitenden Indiumphosphidschicht (InP) größer ist als die Tiefe der Diffusion in der Gallium-Indium-Arsenidschicht, so daß die Tiefe der Diffusion in der Indiumphosphidschicht (InP) wenigstens dem Wert 0,5 μm entspricht und daß die Tiefe der Diffusion in der Gallium-Indium-Arsenidschicht (InGaAs) in der Größenordnung von 0,1 bis 0,2 μm liegt, wobei dieser Vorgang eine p$^+$-leitende Schicht ergibt auf der Oberfläche, an den Rändern und am Umfang der MESA in der Öffnung der vorher gebildeten dielektrischen Schicht;

g) das Bilden einer Metallisierung auf der Rückseite des Trägers;

h) das Bilden eines ohmschen Kontaktes auf der p$^+$-Zone in der n(-)-leitenden Indiumphosphidschicht (InP) am Umfang der MESA;

i) das Bilden einer dielektrischen Antireflexschicht auf der Oberfläche der MESA, wobei die Transparenz auf die Betriebswellenlänge der Photodiode zentriert ist;

j) das Bilden einer dielektrischen Passivierungsschicht an den Rändern der MESA entsprechend und kompatibel zu dem die Antireflexschicht bildenden Dieleltrikum.

7. Verfahren nach Anspruch 6, dadurch gekennzeichnet, daß zwischen den Verfahrensschritten c und d die folgenden Verfahrensschritte durchgeführt werden:

k) das Niederschlagen einer p$^+$-leitenden Gallium-Indium-Arsenidschicht (InGaAs), deren Dicke etwa 0,1 bis 0,2 µm beträgt, auf der vorhergehenden n$^-$-leitenden Gallium-Indium-Arsenidschicht (InGaAs).

l) das Niederschlagen einer zweiten p$^+$-leitenden Indiumphosphidschicht (Inp) durch Epitaxie, wobei die Dicke etwa 1 µm beträgt.

**Claims**

1. A PIN photodiode having a low leakage current comprising a substrate of indium phosphide (InP) of the n$^+$ type, on whose first surface a layer of indium phosphide (InP) of the n$^-$ type is formed, on which a MESA structure formed by a layer of gallium indium arsenide (InGaAs) of the n$^-$ type is disposed, further comprising a p$^+$ layer formed at the surface, at the edges and along the circumference of the MESA structure and further comprising a metallic contact formed on the second surface of the substrate opposite to the first surface and an ohmic contact formed on a part of the p$^+$ layer, characterized in that the n$^-$ doping concentration of the indium phosphide (InP) layer is lower than the n$^-$ doping concentration of the gallium indium arsenide (InGaAs) layer, and in that the ohmic contact is formed on a part of the p$^+$ zone located in the indium phosphide (InP) layer of the n$^-$ type along the circumference of the MESA structure.

2. A photodiode as claimed in Claim 1, characterized in that the thickness of the p$^+$ layer formed at the surface of the layer of gallium indium arsenide (InGaAs) of the n$^-$ type is smaller than the thickness of the p$^+$ zone formed under the ohmic contact in the layer of indium phosphide (InP) of the n$^-$ type along the circumference of the MESA.

3. A photodiode as claimed in Claim 2, characterized in that the MESA structure thus formed is provided with a second layer of indium phosphide (Inp) of the p$^+$ type.

4. A photodiode as claimed in Claim 3, characterized in that the second layer of indium phosphide of the p$^+$ type formed at the surface of the layer of gallium indium arsenide of the p$^+$ type has a thickness of the order of 1µm.

5. A photodiode as claimed in any one of Claim 2, 3 or 4, characterized in that the thickness of the layer of indium phosphide (InP) of the n$^-$ type and of the layer of gallium indium arsenide (InGaAs) of the n$^-$ type is of the order of 3 µm, the n$^-$ doping of the layer of indium phosphide (InP) is of the order of $2.10^{14}$ charge carriers per cm$^3$, the n$^-$ doping of the layer of gallium indium arsenide (InGaAs) is of the order of 1 to $2.10^{15}$ charge carriers per cm$^3$, the thickness of the p$^+$ zone formed in the layer of indium phosphide (InP) of the n$^-$ type along the circumference of the MESA structure is larger than D.5 µm and the thickness of the layer of the p$^+$ type formed at the surface of the layer of gallium indium arsenide of the n$^-$ type is of the order of 0.l to 0.2 µm.

6. A method of manufacturing a diode as claimed in any one of Claims 1 to 5, characterized in that it comprises the steps of:

a) forming a substrate of indium phosphide (InP) of the n$^+$ type,

b) depositing a layer of indium phosphide of the n$^-$ type having a thickness of about 3 µm,

c) depositing a layer of gallium indium arsenide of the n$^-$ type having a doping level higher than that of the preceding layer of InP having a thickness of about 3 µm,

d) masking the surface intended to form the MESA, selectively etching the layer of gallium indium arsenide (InGaAs) and then removing the mask from the surface of the MESA,

e) depositing on the layer of indium phosphide of the n$^-$ type a dielectric layer defining around the MESA an opening having a diameter larger than that of the MESA,

f) diffusing acceptor atoms in such a manner that the diffusion depth in the layer of indium phosphide (InP) of the n$^-$ type is larger than the diffusion depth in the layer of gallium indium arsenide so that the diffusion depth in the indium phosphide (Inp) is at least equal to 0.5 µm and the diffusion depth in the gallium indium arsenide (InGaAs) is of the order of 0.1 to 0.2 µm, this operation producing a layer of the p$^+$ type at the surface, at the edges and along the circumference of the MESA in the opening of the dielectric layer formed beforehand,

g) forming a metallization on the back surface of the substrate,

h) forming an ohmic contact on the p$^+$ zone provided in the layer of indium phosphide (InP) of the n$^-$ type along the circumference of the MESA,

i) forming a dielectric antireflection layer at the surface of the MESA, the transparence of this layer being centered at the operating wavelength of the photodiode,

j) forming at the edges of the MESA a dielectric passivation layer analogous to and compatible with the dielectric forming the antireflection layer.

7. A method as claimed in Claim 6, characterized in that between the steps c and d it comprises the steps:

k) depositing a layer of gallium indium arsenide (InGaAs) of the p$^+$ type having a thickness of about 0.1 to 0.2 µm on the preceding layer of gallium indium arsenide (InGaAs) of the n$^-$ type,

l) depositing a second layer of indium phosphide (Inp) of the p$^+$ type having a thickness of about 1 µm by epitaxy.

FIG.1a

FIG.1b

FIG.2

FIG.3a

FIG.3b

FIG.3c

FIG. 3d

FIG. 3e

FIG. 3f

FIG.3g

FIG.3h

FIG.3i

FIG.4a

FIG.4b

FIG.4c

FIG.4d

FIG. 4e

FIG. 4f

FIG. 4g

FIG.4h

FIG.4i

FIG.4j